# EUROPEAN PATENT APPLICATION

(11) **EP 1 811 058 A2**
(43) Date of publication of application: **25.07.2007**
(21) Application number: 07001119.2
(22) Date of filing: 19.01.2007
(51) Int. Cl.: C23C 14/34, C23C 14/08

(54) **Method of manufacturing insulating target material**

(30) Priority: 19.01.2006 JP 2006011071
(71) Applicant: SEIKO EPSON CORPORATION, Shinjuku-ku, Tokyo 163-0811 (JP)
(72) Inventor: Ohashi, Koji, Suwa-shi, Nagano-ken 392-8502 (JP); Kijima, Takeshi, Suwa-shi, Nagano-ken 392-8502 (JP); Iwashita, Setsuya, Suwa-shi, Nagano-ken 392-8502 (JP); Hamada, Yasuaki, Suwa-shi, Nagano-ken 392-8502 (JP)
(74) Representative: Hoffmann, Eckart

(57) **Abstract**

A method of manufacturing an insulating target material for obtaining an insulating complex oxide film of a general formula AB₁₋ₓCₓO_{3,} the method including: mixing an oxide of an element A, an oxide of an element B, and an oxide of an element C, subjecting the mixed powder to heat treatment, and pulverizing the resulting product to obtain a first powder; mixing the first powder and a solution including at least one of an Si raw material and a Ge raw material and obtaining a second powder from the mixture of the first powder and the solution; subjecting the second powder to heat treatment and pulverizing the resulting product to obtain a third powder; and subjecting the third powder to heat treatment.

## Description

### BACKGROUND OF THE INVENTION

The present invention relates to a method of manufacturing an insulating target material suitably used for radio frequency (RF) sputtering.

A target for obtaining a complex oxide film by sputtering is generally obtained as follows. For example, a target for obtaining a perovskite oxide film of the general formula ABO₃ is obtained by pulverizing oxide raw materials of the element A and the element B, mixing the oxide raw materials taking the stoichiometric composition into consideration, and sintering the mixture. A material disclosed in JP-A-10-176264 has been known as such a target, for example. This document discloses a sputtering target for a perovskite oxide of the chemical formula ABO₃ which has a specific relative density and size.

The inventor of the invention found that a target sufficient for obtaining an insulating complex oxide film of the general formula ABO₃ cannot be obtained by merely pulverizing oxide raw materials of the element A and the element B and mixing and sintering the oxide raw materials at a specific composition.

For example, when producing a target for forming a PZT(Pb(Zr,Ti)O₃) insulating complex oxide film by RF sputtering using a known sintering method, the following finding was obtained. Specifically, a target obtained by mixing a Pb oxide powder, a Zr oxide powder, and a Ti oxide powder at a composition ratio of 1.2:1:1 and sintering the mixture did not exhibit uniform insulating properties over the entire target, in which a portion exhibiting low insulating properties (i.e. portion exhibiting conductivity higher than that of the surrounding portion) was formed. When RF sputtering is performed using such a target, plasma is concentrated on the portion exhibiting low insulating properties. As a result, damage such as cracking or peeling occurs in the target due to plasma concentration. This makes it impossible to use such a target for RF sputtering.

### SUMMARY

According to one aspect of the invention, there is provided a method of manufacturing an insulating target material for obtaining an insulating complex oxide film of a general formula AB₁₋ₓCₓO₃, the method comprising:
mixing an oxide of an element A, an oxide of an element B, and an oxide of an element C, subjecting the mixed powder to heat treatment, and pulverizing the resulting product to obtain a first powder;
mixing the first powder and a solution including at least one of an Si raw material and a Ge raw material and obtaining a second powder from the mixture of the first powder and the solution;
subjecting the second powder to heat treatment and pulverizing the resulting product to obtain a third powder; and
subjecting the third powder to heat treatment.

### BRIEF DESCRIPTION OF THE SEVERAL VIEWS OF THE DRAWING

FIG. 1 is a flowchart showing a method of manufacturing an insulating target material according to one embodiment of the invention.
FIG. 2 is a photograph showing the outward appearance of an insulating target material of Example 1 according to the invention.
FIG. 3 is a photograph of an insulating target material of Comparative Example 1.

### DETAILED DESCRIPTION OF THE EMBODIMENT

The invention may provide a method of manufacturing an insulating target material for obtaining an insulating complex oxide film, the insulating target material being uniform and exhibits excellent insulating properties and excellent characteristics.

According to one embodiment of the invention, there is provided a method of manufacturing an insulating target material for obtaining an insulating complex oxide film of a general formula AB₁₋ₓCₓO₃, the method comprising:
mixing an oxide of an element A, an oxide of an element B, and an oxide of an element C, subjecting the mixed powder to heat treatment, and pulverizing the resulting product to obtain a first powder;
mixing the first powder and a solution including at least one of an Si raw material and a Ge raw material and obtaining a second powder from the mixture of the first powder and the solution;
subjecting the second powder to heat treatment and pulverizing the resulting product to obtain a third powder; and
subjecting the third powder to heat treatment.

According to the above manufacturing method, an insulating target material which is uniform and exhibits excellent insulating properties can be obtained. An insulating target material obtained by the above manufacturing method may be suitably applied for RF sputtering due to its uniformity and excellent insulating properties.

In this method of manufacturing an insulating target material,
the element A may be at least one element selected from Pb, Bi, Sr, La, Ce, Pr, Nd, Pm, Sm, Eu, Gd, Tb, Dy, Ho, Er, Tm, Yb, and Lu;
the element B may be at least one element selected from Zr, Ti, V, Bi, W, and Hf; and
the element C may be at least one element selected from Nb and Ta.

In this method of manufacturing an insulating target material,
the element A may include at least Pb;
the element B may be Zr and Ti; and
the element C may be at least one of Nb and Ta.

In this method of manufacturing an insulating target material, the solution may include at least one of the Si raw material and the Ge raw material in an amount of 2 to 10 mol%.

In this method of manufacturing an insulating target material, the mixed powder may be subjected to the heat treatment at 900 to 1000° C.

In this method of manufacturing an insulating target material, the second powder may be subjected to the heat treatment at 900 to 1000° C.

In this method of manufacturing an insulating target material, the third powder may be subjected to the heat treatment at 1000 to 1500° C.

The embodiments of the invention will be described in detail below.

### 1. Insulating target material

An insulating target material obtained by a manufacturing method according to one embodiment of the invention is described below. This insulating target material is an insulating target material for obtaining an insulating complex oxide film of the general formula AB₁₋ₓCₓO₃ and comprises an oxide of an element A (first element), an oxide of an element B (second element), an oxide of an element C (third element), and at least one of an Si compound and a Ge compound.

In the insulating target material obtained by the manufacturing method according to this embodiment, at least the element A, the element B, and the element C are included in the insulating target material as oxides.

The element A may be at least one element selected from Pb, Bi, Sr, La, Ce, Pr, Nd, Pm, Sm, Eu, Gd, Tb, Dy, Ho, Er, Tm, Yb, and Lu. The element B may be at least one element selected from Zr, Ti, V, Bi, W, and Hf. The element C may be at least one element selected from Nb and Ta.

It is preferable that the element A include at least Pb, the element B be Zr and Ti, and the element C be at least one of Nb and Ta, and preferably Nb.

An oxygen deficiency in the resulting insulating complex oxide film can be compensated for by incorporating the element C in the insulating target material. Moreover, even if high-temperature heat treatment is performed in the method of manufacturing an insulating target material described later, a stable insulating target material can be obtained by incorporating the element C.

An insulating target material which is uniform and exhibits excellent insulating properties can be obtained by incorporating at least one of the Si compound and the Ge compound in the insulating target material, as is clear from the examples described later. It is preferable that the insulating target material include at least the Si compound of the Si compound and the Ge compound. It is preferable that the Si compound and the Ge compound be oxides.

The oxide of the element A, the oxide of the element B, and the oxide of the element C may be included in the insulating target material according to this embodiment at the same ratio as the stoichiometric composition of the resulting insulating complex oxide (general formula AB₁₋ₓCₓO₃), that is, at a ratio of A:B:C = 1: 1 - x:x or a ratio close thereto. x is preferably in the range of 0.1≤x≤0.3, and still more preferably 0.15≤x≤0.25. When the element A is lead (Pb), the insulating target material may include lead in excess over the stoichiometric ratio of the insulating complex oxide since lead easily evaporates.

As examples of the insulating complex oxide to which the insulating target material can be applied, Pb(Zn,Ti)₁₋ₓNbₓO₃ and the like can be given.

### 2. Method of manufacturing insulating target material

An insulating target material according to one embodiment of the invention may be formed by using the following method. This insulating target material is a target material for obtaining an insulating complex oxide film of the general formula AB₁₋ₓCₓO₃.

The manufacturing method according to this embodiment comprises mixing an oxide of an element A, an oxide of an element B, and an oxide of an element C, subjecting the mixed powder to heat treatment, and pulverizing the resulting product to obtain a first powder, mixing the first powder and a solution including at least one of an Si raw material and a Ge raw material and collecting the resulting powder to obtain a second powder, subjecting the second powder to heat treatment and pulverizing the resulting product to obtain a third powder, and subjecting the third powder to heat treatment.

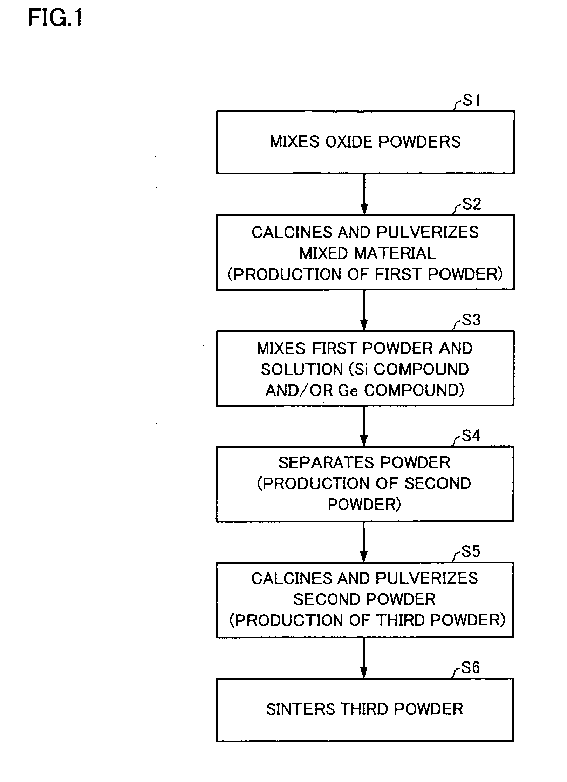

Specifically, the manufacturing method according to this embodiment may include the steps shown in FIG. 1.

### (1) Production of first powder

A powder of the oxide of the element A, a powder of the oxide of the element B, and a powder of the oxide of the element C are mixed in a composition ratio of 1:1-x:x or a ratio close thereto, for example (step S1). The composition is not necessarily limited to the above composition ratio depending on the combination of each element. For example, when the element A is lead, lead may be contained in excess over the stoichiometric ratio of the desired insulating complex oxide. Specifically, when the element A is lead, the composition ratio may be 1 to 1.3:1-x:x, for example.

The resulting mixed material is calcined at 900 to 1000° C and pulverized to obtain a first powder (step S2). The resulting first powder includes the oxide of the element A, the oxide of the element B, and the oxide of the element C.

### (2) Production of second powder

The first powder and a solution including at least one of an Si raw material and a Ge raw material (Si raw material and/or Ge raw material) are mixed (step S3). As the Si raw material or the Ge raw material, an alkoxide, an organic acid salt, an inorganic acid salt, or the like which may be used as a precursor material for a sol-gel method or a metalorganic decomposition (MOD) method may be used. As the solution, a solution prepared by dissolving the Si raw material and/or the Ge raw material in an organic solvent such as an alcohol may be used. The Si raw material and/or the Ge raw material may be included in the solution in an amount of 2 to 10 mol% of the insulating complex oxide of the general formula AB₁₋ₓCₓO₃.

The Si raw material and the Ge raw material are preferably liquid at room temperature or soluble in a solvent. As examples of the compound which may be used, an organic salt, an alkoxide, an inorganic salt, and the like can be given. As specific examples of the organic salt, a formate, acetate, propionate, butyrate, octylate, stearate, and the like of Si and Ge can be given. As specific examples of the alkoxide, an ethoxide, propoxide, butoxide, and the like of Si and Ge can be given. The alkoxide may be a mixed alkoxide. As specific examples of the inorganic salt, a hydroxide, chloride, fluoride, and the like of Si and Ge can be given. These compounds may be directly used when liquid at room temperature, or may be used after dissolving the compound in another solvent. The Si raw material and the Ge raw material are not limited to these compounds. A number of other Si salts and Ge salts may also be suitably used.

The powder and the solution are then separated by filtration or the like to obtain a second powder (step S4). The resulting second powder is a product obtained by mixing the first powder and the solution.

### (3) Production of third powder

The second powder is calcined at 900 to 1000° C and pulverized to obtain a third powder (step S5). The resulting third powder includes the oxide of the element A, the oxide of the element B, the oxide of the element C, and the oxide of Si and/or Ge.

### (4) Sintering

The third powder is sintered using a known method (step S6). For example, the third powder may be placed in a die and sintered by vacuum hot pressing. The third powder may be sintered at 1000 to 1500° C. An insulating target material may be thus obtained.

### (5) Grinding

The resulting insulating target material may be ground on the surface by wet grinding, as required.

The manufacturing method according to this embodiment allows an insulating target material which is uniform and exhibits excellent insulating properties to be obtained due to inclusion of the step of mixing the first powder and the solution of the Si raw material and/or the Ge raw material, as is clear from the examples described later. Moreover, the manufacturing method according to this embodiment allows an insulating target material which is uniform and exhibits excellent insulating properties to be obtained, even if the manufacturing method includes the high-temperature heat treatment step, due to incorporation of the oxide of the element C in the first powder.

### 3. Insulating complex oxide film

An insulating complex oxide film of the general formula AB₁₋ₓCₓO₃ may be obtained by RF sputtering using the insulating target material obtained by the manufacturing method according to this embodiment. The insulating complex oxide film includes at least one of Si and Ge, and preferably at least Si. The insulating complex oxide film of the general formula AB₁₋ₓCₓO₃ may include at least one of Si and Ge in an amount of 0.001 to 5 mol %, and preferably 0.001 to 1 mol % .

### 4. Examples

An example according to the invention and a comparative example are described below. Note that the invention is not limited to the following examples.

### 4.1. Example 1 and Comparative Example 1

An insulating target according to Example 1 was formed using the following method.

A first powder was produced. Specifically, a powder of an oxide of Pb, a powder of an oxide of Zr, a powder of an oxide of Ti, and a powder of an oxide of Nb were mixed at a composition ratio of 1.2:0.33:0.47:0.2. The resulting mixed material was calcined at 900 to 1000° C and then pulverized to obtain a first powder.

A second powder was then produced. Specifically, the first powder and a silicon alkoxide solution were mixed. The silicon alkoxide solution is a product prepared by dissolving a silicon alkoxide in an alcohol in an amount of 5 mol%.

The powder and the solution were then separated by filtration to obtain a second powder. The resulting second powder was obtained by mixing the first powder and the above solution.

The second powder was calcined at 900 to 1000° C and then pulverized to obtain a third powder.

The third powder was sintered using a known method. In more detail, the third powder was placed in a die and sintered by vacuum hot pressing. The third powder was sintered at 1400° C. A target sample 1 of Example 1 was thus obtained. The composition of the target sample 1 was as follows.

### PZTN (Pb_{1.2}Zr_{0.33}Ti_{0.47}Nb_{0.2}Oₓ)-SiO₂ (2 wt%)

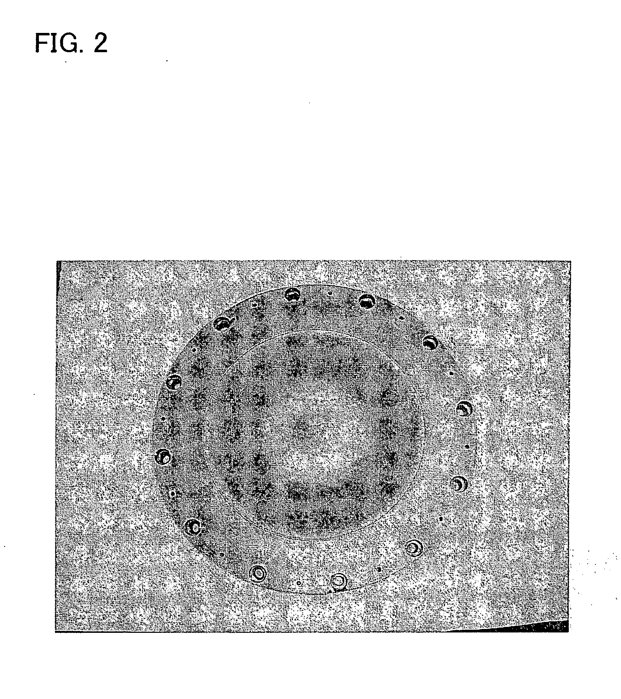

FIG. 2 shows a photograph of the surface of the target sample 1. As shown in FIG. 2, it was confirmed that the target sample of Example 1 had a uniform surface and did not contain defects such as cracks. RF sputtering was carried out using the target sample 1. It was confirmed that an excellent insulating complex oxide film was obtained using the target sample 1.

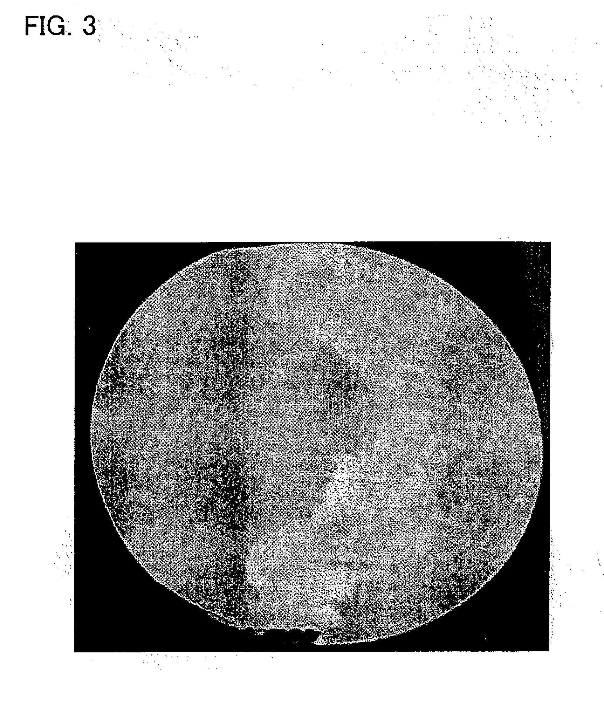

Comparative Example 1 is described below. In Comparative Example 1, a target sample 2 was obtained in the same manner as in Example 1 except that the first powder did not include the powder of the oxide of Nb and the step of forming the second powder by mixing the first powder and the solution was omitted. Specifically, the target sample 2 of Comparative Example 1 was obtained by directly sintering the first powder of Example 1. The surface of the target sample 2 was observed. It was confirmed that the target sample 2 had a nonuniform surface, as shown in FIG. 3. RF sputtering was carried out using the target sample 2. It was confirmed that the target sample 2 cannot be used in practice due to breakage.

The invention is not limited to the above-described embodiments, and various modifications can be made. For example, the invention includes various other configurations substantially the same as the configurations described in the embodiments (in function, method and result, or in objective and result, for example). The invention also includes a configuration in which an unsubstantial portion in the described embodiments is replaced. The invention also includes a configuration having the same effects as the configurations described in the embodiments, or a configuration able to achieve the same objective. Further, the invention includes a configuration in which a publicly known technique is added to the configurations in the embodiments.

## Claims

1. A method of manufacturing an insulating target material for obtaining an insulating complex oxide film of a general formula AB₁₋ₓCₓO₃, the method comprising:
mixing an oxide of an element A, an oxide of an element B, and an oxide of an element C, subjecting the mixed powder to heat treatment, and pulverizing the resulting product to obtain a first powder;
mixing the first powder and a solution including at least one of an Si raw material and a Ge raw material and obtaining a second powder from the mixture of the first powder and the solution;
subjecting the second powder to heat treatment and pulverizing the resulting product to obtain a third powder; and
subjecting the third powder to heat treatment.

2. The method of manufacturing an insulating target material as defined in claim 1,
wherein the element A is at least one element selected from Pb, Bi, Sr, La, Ce, Pr, Nd, Pm, Sm, Eu, Gd, Tb, Dy, Ho, Er, Tm, Yb, and Lu;
wherein the element B is at least one element selected from Zr, Ti, V, Bi, W, and Hf; and
wherein the element C is at least one element selected from Nb and Ta.

3. The method of manufacturing an insulating target material as defined in claim 2,
wherein the element A includes at least Pb;
wherein the element B is Zr and Ti; and
wherein the element C is at least one of Nb and Ta.

4. The method of manufacturing an insulating target material as defined in any one of claims 1 to 3,
wherein the solution includes at least one of the Si raw material and the Ge raw material in an amount of 2 to 10 mol % .

5. The method of manufacturing an insulating target material as defined in any one of claims 1 to 4,
wherein the mixed powder is subjected to the heat treatment at 900 to 1000° C.

6. The method of manufacturing an insulating target material as defined in any one of claims 1 to 5,
wherein the second powder is subjected to the heat treatment at 900 to 1000° C.

7. The method of manufacturing an insulating target material as defined in any one of claims 1 to 6,
wherein the third powder is subjected to the heat treatment at 1000 to 1500° C.
